(19) **Europäisches Patentamt / European Patent Office / Office européen des brevets**

(11) **EP 1 692 733 B1**

(12) **EUROPEAN PATENT SPECIFICATION**

(45) Date of publication and mention
of the grant of the patent:
**10.06.2009 Bulletin 2009/24**

(21) Application number: **04801424.5**

(22) Date of filing: **01.12.2004**

(51) Int Cl.:
*H01L 27/32* (2006.01)       *H01L 51/52* (2006.01)

(86) International application number:
**PCT/IB2004/052615**

(87) International publication number:
**WO 2005/055332 (16.06.2005 Gazette 2005/24)**

(54) **DISPLAY WITH REFLECTIVE ISOLATING SEPARATOR LAYER**

DISPLAY MIT EINER REFLEKTIERENDEN ISOLIERENDEN TRENNSCHICHT

AFFICHEUR A COUCHE DE SEPARATION ISOLANTE REFLECHISSANTE

(84) Designated Contracting States:
**AT BE BG CH CY CZ DE DK EE ES FI FR GB GR
HU IE IS IT LI LT LU MC NL PL PT RO SE SI SK TR**

(30) Priority: **03.12.2003 EP 03104528**

(43) Date of publication of application:
**23.08.2006 Bulletin 2006/34**

(73) Proprietors:
• **Philips Intellectual Property & Standards GmbH
20099 Hamburg (DE)**
Designated Contracting States:
**DE**
• **Koninklijke Philips Electronics N.V.
5621 BA Eindhoven (NL)**
Designated Contracting States:
**AT BE BG CH CY CZ DK EE ES FI FR GB GR HU
IE IS IT LI LT LU MC NL PL PT RO SE SI SK TR**

(72) Inventors:
• **BECHTEL, Hans-Helmut,
Philips IP & Standards GmbH
52066 Aachen (DE)**
• **BUSSELT, Wolfgang,
Philips IP & Standards GmbH
52066 Aachen (DE)**

(74) Representative: **Volmer, Georg
Philips Intellectual Property & Standards GmbH
Postfach 50 04 42
52088 Aachen (DE)**

(56) References cited:
**EP-A- 1 077 589          US-B1- 6 307 528**

• PATENT ABSTRACTS OF JAPAN vol. 2003, no. 05, 12 May 2003 (2003-05-12) -& JP 2003 031355 A (PIONEER ELECTRONIC CORP), 31 January 2003 (2003-01-31)
• PATENT ABSTRACTS OF JAPAN vol. 2003, no. 12, 5 December 2003 (2003-12-05) -& JP 2003 303677 A (DAINIPPON PRINTING CO LTD), 24 October 2003 (2003-10-24)
• PATENT ABSTRACTS OF JAPAN vol. 2003, no. 08, 6 August 2003 (2003-08-06) -& JP 2003 100464 A (SANYO ELECTRIC CO LTD), 4 April 2003 (2003-04-04)
• PATENT ABSTRACTS OF JAPAN vol. 2003, no. 12, 5 December 2003 (2003-12-05) -& JP 2004 119197 A (SEIKO EPSON CORP), 15 April 2004 (2004-04-15)

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

The present invention relates to a display, in particular to an organic LED (OLED) display.

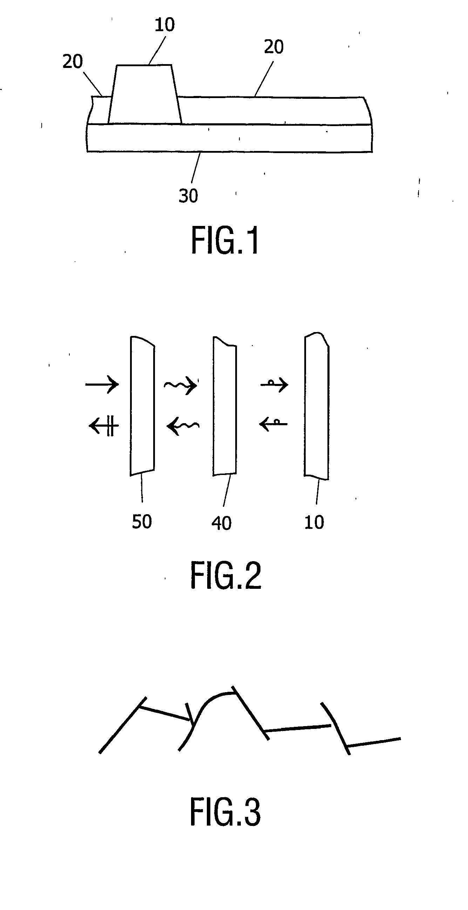

OLED-Displays as known in the art comprise in general a structure as - very schematically - shown in Fig. 1- On a screen glass 30 one or several light emitting layers 20 are located (together with other layers such as hole- and electron transporting layers sandwiched between two electrodes not shown in the fig.) with laterally adjacent isolating separator layers 10, which separate two different light emitting layers. The separator layers can be higher than the emitting layers as shown in Fig. 1. It is also possible that the separator layer lies underneath the emitting layer, separating different pixels of a display towards the substrate only. These isolating separators usually consist out of a material called "Black Matrix". i.e. a material, which is not reflective.

When light is emitted from the light emitting layer, for example by a recombination of a hole and electron in a OLED, the light is send out from the light emitting layer in various directions, amongst them in directions projecting towards the separators 10. Normally, light propagating in the substrate cannot leave the display. In particular, if light falls on this "Black Matrix", it is absorbed and therefore can never leave the display. This leads to an unwanted decay in luminance performance of the display.

US6307528 discloses a organic light emitting pixel structure with improved contrast due to vertical walls around each pixel blocking out light emitted from adjacent pixels.

JP2003031355 discloses a display panel with a luminous layer partitioned into picture elements by partition walls onto the luminous layer side, where the partition walls are provided with a reflecting means leading to an improved light takeout.

JP2003303677 discloses self-luminous elements such as an EL or a PDP elements with partition walls in between for diffusing and reflecting light emitted at a larger angle than the critical angle from the luminous layer toward an interface of a transparent substrate and the outside is fitted inside the transparent substrate.

JP2003100464 discloses a display with an organic light emitting layer formed in the shape of stripes, where metal reflective ribs are arranged between the stripes of this organic layer. However, depending on the form of the reflectors a part of the light emitted from the emitting layer would not be able to leave the display due to total reflection.

It is therefore an objective to provide a display that has a higher luminance performance.

This objective is achieved by providing a display comprising a ground plate and at least one emitting layer and at least one isolating separator layer each positioned in contacting manner on said ground plate, the at least one emitting layer and the at least one isolating separator layer being positioned adjacent to each other in a contacting manner, whereby the isolating separator layer is reflective, characterized in, that the material of said at least one isolating separator layer comprises a metal material with a flake-structure.

The surface of the flakes are passivated by formation of oxides or other passivation methods. So as a result, the isolating separator layer is electrically isolating and with metal reflection properties. Preferably, the material of said at least one isolating separator layer comprises a material selected from a group containing Al, V, Cr, Mn. A most preferred isolating separator layer comprises aluminium-flakes. These aluminium flakes can e.g. be obtained by EckartWerke, Fürth, Germany, as Metalure® metallic dispersions. The typical average and insofar preferred particle size of the pigments used within the present invention, especially but not limited to the Metalure® pigments is in the range of 9 -14 $\mu$m. The total reflectance of layers according to a preferred embodiment of the present invention, especially but not limited to layers using Metalure® dispersions is preferably $\geq$ 60%, more preferably $\geq$ 70%, yet more preferably $\geq$ 80% and most preferably $\geq$ 85% and $\leq$ 100%. A preferred key characteristic for a preferred embodiment of the present invention is the possibility to adjust the flake orientation, as e.g. described in Li-Piin Sung et al., Journal of Coatings Technology, 74, 932 (2002) 55, which is hereby fully incorporated by reference. Depending on the flake processing conditions, the flake orientation can be chosen to exhibit an angle with the substrate. In this way the reflectance of the separator layer changes the angle for light trapped in the substrate, while the reflection itself is mainly metallic in nature.

A ground plate in the sense of the invention is in particular a flat substrate with a transparent electrode structure, on which the emitting layer and the isolating separator layer can be positioned to extend longitudinally and/or latitudinally along the flat surface of the substrate. A suitable ground plate is e.g. a glass screen with an ITO (Indium-Tin-Oxide) layer as transparent electrode (Anode) or screen. For the ground plate other transparent materials than glass can be used and the transparent electrode can be formed by other conductive materials. It is also possible that other transparent or semi-transparent dielectric layers are located between the substrate and the electrode. In addition the ground plate may carry electronic elements, i.e. thin film transistors, used for pixel addressing of the device.

"Reflective" in the sense of the present invention means that the isolating separator layer is $\geq$50 % reflective, more preferred $\geq$70 % reflective, more preferred $\geq$80 % reflective, more preferred $\geq$85 % reflective, further more $\geq$90 % reflective and most preferred $\leq$100 % reflective.

By that way, the light that was sent out from the light emitting layer towards the separator is reflected into angles which will allow it to leave through the substrate.

It should be noted, that the isolating separator layer may overlap the emitting layer on that side of the emitting layer that projects from the ground plate. By this way, also light that is emitted from the light-emitting layer away from the ground plate is reflected in a way that will allow it to leave the display.

Preferably, the thickness of the isolating separator layer is between ≥ 10 nm and ≤ 10μm, more preferred between ≥ 30 nm and ≤ 8μm, yet more preferred between ≥ 50 nm and ≤ 5μm and most preferred between ≥ 100 nm and ≤ 3μm.

Preferably, the thickness of the light emitting layer is between ≥ 1 nm and ≤ 200 nm, whereas preferred thickness regions of the light emitting layer are between ≥ 1 nm and ≤ 10 nm, between ≥ 10 nm and ≤ 50 nm, between ≥ 50 nm and ≤ 200 nm and between ≥ 60 nm and ≤ 100 nm.

Preferably, the thickness of the ground plate is between ≥ 30μm and ≤ 10mm, whereas preferred thickness regions of the ground plate are between 5mm and ≤ 10mm, between ≥ 2mm and ≤5mm, between ≥ 1mm and ≤ 2mm and most preferred between ≥ 30μm and ≤ 51mm.

In a further preferred embodiment of the present invention, the display comprises at least one λ/4 plate and at least one linear polarisation layer positioned between said ground plate and said isolating separator layer in such a way, that light that moves from the ground plate towards the isolating separator layer as well as light that moves from said isolating separator layer towards said ground plate is forced to pass said at least one λ/4 plate and at least one linear polarisation layer. By such an arrangement, incoming light that falls on the display is not reflected although the isolating separator layer is reflective. Light that passes through said at least one λ/4 plate and at least one linear polarisation layer and is reflected by the isolating separator layer has, after passing once again the at least one λ/4 plate a polarization angle which is perpendicular to the initial polarization angle and therefore cannot pass the at least one linear polarisation layer. For this reason, in a further preferred embodiment the surface of said at least one isolating separator is specular reflective.

According to a further preferred embodiment of the present invention, light impinging on said at least one isolating separator layer in an angle is at least to a part reflected in a different angle. By doing so, at least part of the light emitted from the emitting layer that would not be able to leave the display due to total reflection on the ground plate is able to do so, since the angle is changed by the isolating separator layer.

Further advantages and features of the present invention can be seen together with the accompanying figures in which

     Fig.1 shows a very schematic crossview structure of an isolating separator, a light-emitting layer and a ground plate according to a first embodiment of the present invention;

     Fig. 2 shows - very schematically - the way of light through a polarisation layer, a λ/4 plate and an isolating separator layer according to a preferred embodiment of the present invention;

     Fig. 3 shows- very schematically - the surface structure of an isolating separator layer according to a preferred embodiment of the present invention; and

     Fig. 4 shows the way of a light projected from the light-emitting layer towards the glass screen in a display according to a preferred embodiment of the present invention.

Fig.1 shows - very schematically - a part of the structure of a display of a first embodiment of the present invention. On a ground plate 30, which may be a glass screen with a structure of transparent electrodes, one or several light emitting layers 20 are located (together with other layers such as hole transporting layers not shown in the fig.) with laterally adjacent isolating separator layers 10 positioned in a contacting manner, which separate two different light emitting layers 20. The structure and design of the isolating separator layer 10, the light- emitting layer 20 and the ground plate 30, which is preferably formed in form of a glass screen with transparent electrode structure, as such are prior art and are therefore not discussed in detail. However, any structures known in the art may be used within the present invention.

Fig. 2 shows the way of light through a polarisation layer 50, a λ/4 plate 40 and an isolating separator layer 10 according to a preferred embodiment of the present invention. According to this embodiment the display comprises at least one λ/4 plate 40 and at least one linear polarisation layer 50 positioned between said ground plate 30 and said isolating separator layer 10 in such a way, that light that moves from the ground plate 30 towards the isolating separator layer 10 as well as light that moves from said isolating separator layer 10 towards said ground plate 30 is forced to pass said at least one λ/4 plate 40 and at least one linear polarisation layer 50. It is furthermore preferred that the surface of the isolating separator layer 10 is specular reflective.

By doing so, the reflection of light falling on the display can be reduced. This is done in the way as - very schematically - shown in Fig. 2

Incoming light falls on the polarisation layer 50, where e.g. only horizontally polarized light is let through. Via an λ/4 plate 40, the light is transferred to a circular polarized light, which optionally passes through various other layers (not shown in Fig. 2) and finally falls on the isolating separator layer 10. Through reflection of the isolating separator layer 10, the light is reflected to the λ/4 plate 40, however, the polarization direction is changed by this reflection in such way that after passing the λ/4 plate 40 the light is now vertically polarized. This light cannot pass the polarization layer 50, which in the end results in an absorption of the incoming light. Via such a display, incoming light is not reflected, but emitted light from the light emitting layer is. This leads to a dramatic increase in the so-called Luminance Contrast Performance as compared to displays known in the art.

The Luminance Contrast Performance (LCP) is defined as

$$LCP = \frac{Luminance}{\sqrt[2]{Reflection}}$$

Displays as known from the state of the art using a "black matrix" that is not reflective and a Display as described above will have approximately the same reflection; however, due to the favourable reflection of light that was emitted from the light-emitting layer towards the isolating separator layer according to the present invention, this light will be luminated, too, thus increasing the LCP.

In a further preferred embodiment, light impinging on said at least one isolating separator layer 10 in an angle is at least to a part reflected in a different angle. This results e.g. out of a surface structure of the isolating separator layer 10 as - very schematically - shown in Fig. 3. As can be seen in Fig. 3, the surface structure consists of various flat surfaces, which are positioned adjacent to each other with an angle. Light falling on a first surface will be reflected in the same angle as the incoming angle (just as in a usual mirror), however, since the flat surfaces are positioned with an angle from each other, light falling on a second surface will be reflected in another angle as compared as light falling on the first one. A surface structure as shown in Fig. 3 can e.g. be achieved by using aluminium flakes as described above.

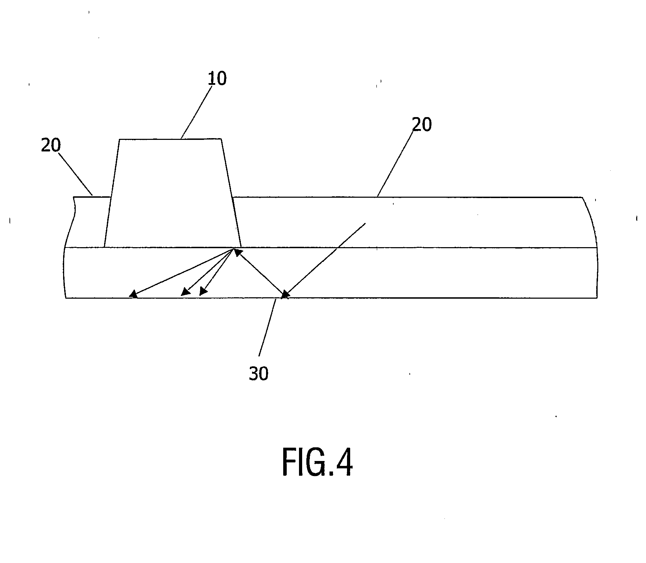

An isolating separator layer 10 with a surface structure as shown in Fig. 3 has the following advantage as shown in Fig. 4, which shows the way of a light projected from the light-emitting layer 20 towards the ground plate 30 in a display according to a preferred embodiment of the present invention.

In displays as known in the prior art, most of the light that is emitted from the light-emitting layer 20 towards the ground plate 30 has such an angle that total-reflection occurs. This light will therefore not leave the ground plate 30, thus reducing the luminance of the display.

With an isolating separator layer 10 as described above and shown in Fig.4, light (as indicated by the arrows) that was emitted from the light-emitting layer 20 and total-reflected by the ground plate 30 will be reflected by the isolating separator layer 10 in various angles. Therefore, ,at least part of the light (if not all) will then be able to leave the ground plate 30 and the display.

According to an example of this invention a metallic separator layer structure is applied in a lift off process. A glass plate containing required driving electronics and transparent electrodes is coated with a photoresist layer [polyvinylpyrrolidone PVP K-90, obtainable from BASF]: [di(4-azido-2-sulfonylbenzylidene)acetone disodium, obtainable from TGK] ratio 1:10, UV-exposed, dried and developed. After this processing step, the photoresist is removed from the substrate plate where the separator layer is located. Then a 2 $\mu$m thick metal layer from a Metalure® W2002 dispersion is deposited by spin-coating. After 10 minutes drying at 80°C, the screen is wetted with diluted nitric acid. After 2 minutes, the photoresist together with the Metalure® layer above it is removed under high pressure water jet. After drying, a 200 nm thick PEDOT Buffer layer (Baytron® P from H.C. Starck) is printed and dried for 1 minute at 200°C. Then the red, green and blue emitting polymer layers are printed consecutively with a thickness of 70 nm. Cathode deposition and packaging finalizes device preparation.

A display according to the present invention is preferred contained in a display device for use in household applications, portable applications, monitor applications, computer applications.

**Claims**

1. A display comprising a ground plate (30) and at least one light-emitting layer (20) and at least one isolating separator layer (10) each positioned in contacting manner on said ground plate (30), the at least one emitting layer (20) and the at least one isolating separator layer (10) being positioned adjacent to each other in a contacting manner, whereby the isolating separator layer (10) is reflective, **characterized in, that** the material of said at least one isolating separator layer (10) comprises a metal material with a flake structure, which is on the surface of the flakes passivated by formation of oxides or other passivation methods.

2. The display of Claim 1, whereby the metal material of said at least one isolating separator layer (10) comprises a material selected from a group containing Al, V, Cr, Mn.

3. The display of Claim 2 whereby the material of said at least one isolating separator layer (10) comprises aluminium-flakes.

4. The display according to any of the Claims 1 to 3, whereby the display comprises at least one $\lambda$/4 plate (40) and at least one linear polarisation layer (50) positioned on the ground plate (30) opposing said isolating separator layer (10) in such a way, that ambient light that moves through the ground plate (30) towards the isolating separator layer (10) as well as light that moves from said isolating separator layer (10) towards said ground plate (30) is forced to pass said at least one $\lambda$/4 plate (40) and at least one linear polarisation layer (50).

**5.** The display according to any of the claims 1 to 4, whereby the surface of said at least one isolating separator (10) is specular reflective

**6.** The display according to any of the claims 1 to 5, whereby light impinging on said at least one isolating separator layer (10) in an angle is at least to a part reflected in a different angle.

**7.** Use of display device according to any of the claims 1 to 6 in household applications, portable applications, monitor applications, computer applications.

**Patentansprüche**

**1.** Anzeigeeinrichtung mit einer Grundplatte (30) und mindestens einer Licht emittierenden Schicht (20) sowie mindestens einer isolierenden Trennschicht (10), welche jeweils einander kontaktierend auf der Grundplatte (30) positioniert sind, wobei die mindestens eine Licht emittierende Schicht (20) und die mindestens eine isolierende Trennschicht (10) in Angrenzung aneinander und einander kontaktierend positioniert sind, wobei die isolierende Trennschicht (10) reflektierend ist,
**dadurch gekennzeichnet, dass**
das Material der mindestens einen isolierenden Trennschicht (10) ein Metallmaterial mit einer Plättchenstruktur umfasst, welche auf der Oberfläche der Plättchen durch Ausbildung von Oxiden oder andere Passivierungsverfahren passiviert wird.

**2.** Anzeigeeinrichtung nach Anspruch 1, wobei das Metallmaterial der mindestens einen isolierenden Trennschicht (10) ein Material umfasst, welches aus einer Gruppe enthaltend Al, V, Cr, Mn ausgewählt wird.

**3.** Anzeigeeinrichtung nach Anspruch 2, wobei das Material der mindestens einen isolierenden Trennschicht (10) Aluminiumplättchen umfasst.

**4.** Anzeigeeinrichtung nach einem der Ansprüche 1 bis 3, wobei die Anzeigeeinrichtung mindestens eine $\lambda$/4-Platte (40) und mindestens eine lineare Polarisationsschicht (50) umfasst, die auf der, der isolierenden Trennschicht (10) gegenüberliegenden Grundplatte (30) so positioniert sind, dass Umgebungslicht, welches sich durch die Grundplatte (30) zu der isolierenden Trennschicht (10) hin bewegt, sowie Licht, welches sich von der isolierenden Trennschicht (10) zu der Grundplatte (30) hin bewegt, gezwungen wird, durch die mindestens eine $\lambda$/4-Platte (40) und mindestens eine lineare Polarisationsschicht (50) hindurchzugehen.

**5.** Anzeigeeinrichtung nach einem der Ansprüche 1 bis 4, wobei die Oberfläche der mindestens einen isolierenden Trennschicht (10) spiegelnd reflektierend ist.

**6.** Anzeigeeinrichtung nach einem der Ansprüche 1 bis 5, wobei Licht, welches auf die mindestens eine isolierende Trennschicht (10) in einem Winkel auftrifft, zumindest zu einem Teil in einem anderen Winkel reflektiert wird.

**7.** Verwendung einer Anzeigeeinrichtung nach einem der Ansprüche 1 bis 6 bei Haushaltsanwendungen, portablen Anwendungen, Monitoranwendungen, Computeranwendungen.

**Revendications**

**1.** Afficheur comprenant une plaque de mise à la terre (30) et au moins une couche émettrice de lumière (20) et au moins une couche séparatrice isolante (10), chacune positionnée en contact sur ladite plaque de mise à la terre (30), l'au moins une couche émettrice (20) et l'au moins une couche séparatrice isolante (10) étant positionnées de façon adjacente l'une à l'autre en contact, dans lequel la couche séparatrice isolante (10) est réfléchissante,
**caractérisé en ce que**
le matériau de ladite au moins une couche séparatrice isolante (10) comprend un matériau métallique avec une structure de lamelles, qui est sur la surface des lamelles passivée par formation d'oxydes ou d'autres procédés de passivation.

**2.** Afficheur selon la revendication 1, dans lequel le matériau métallique de ladite au moins une couche séparatrice isolante (10) comprend un matériau sélectionné parmi un groupe contenant Al, V, Cr, Mn.

**3.** Afficheur selon la revendication 2 dans lequel le matériau de ladite au moins une couche séparatrice isolante (10) comprend des lamelles d'aluminium.

**4.** Afficheur selon l'une quelconque des revendications 1 à 3, dans lequel l'afficheur comprend au moins une plaque $\lambda$/4 (40) et au moins une couche de polarisation linéaire (50) positionnées sur la plaque de mise à la terre (30) en face de ladite couche séparatrice isolante (10) de manière telle que la lumière ambiante qui se déplace à travers la plaque de mise à la terre (30) vers la couche séparatrice isolante (10) ainsi que la lumière qui se déplace à partir de ladite couche séparatrice isolante (10) vers ladite plaque de mise à la terre (30) soit forcée de passer à travers ladite au moins une plaque $\lambda$/4 (40) et au moins une couche de polarisation linéaire (50).

**5.** Afficheur selon l'une quelconque des revendications 1 à 4, dans lequel la surface de ladite au moins une couche séparatrice isolante (10) est réfléchissante spéculaire.

6. Afficheur selon l'une quelconque des revendications 1 à 5, dans lequel la lumière incidente sur ladite au moins une couche séparatrice isolante (10) dans un angle est au moins en partie réfléchie dans un angle différent.

7. Utilisation d'un dispositif afficheur selon l'une quelconque des revendications 1 à 6 destiné à être utilisé dans des applications domestiques, des applications portables, des applications de moniteur, des applications informatiques.

FIG.1

FIG.2

FIG.3

FIG.4

**EP 1 692 733 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 6307528 B
- JP 2003031355 B
- JP 2003303677 B
- JP 2003100464 B

### Non-patent literature cited in the description

- **Li-Piin Sung et al.** *Journal of Coatings Technology,* 2002, vol. 74, 932